# FASCICULE DE BREVET EUROPEEN

(11) **EP 1 147 426 B1**
(45) Date de publication et mention de la délivrance du brevet: **22.12.2004**
(21) Numéro de dépôt: 00900544.8
(22) Date de dépôt: 10.01.2000
(51) Int. Cl.: G01R 1/22

(54) **PINCE DE MESURE D'UN COURANT CIRCULANT DANS DES CONDUCTEURS**
MESSZANGE FÜR STROMLEITER
CLIP-ON AMMETER FOR MEASURING A CURRENT CIRCULATING IN CONDUCTORS

(30) Priorité: 12.01.1999 FR 9900215
(43) Date de publication de la demande: 24.10.2001
(73) Titulaire: Universal Technic, 75011 Paris (FR)
(72) Inventeur: LANDRE, Bernard, F-75020 Paris (FR)
(74) Mandataire: Fruchard, Guy
(86) Numéro de dépôt international: PCT/FR2000/000032
(87) Numéro de publication internationale: WO 2000/042441

(56) Documents cités:
- FR-A- 2 673 727

## Description

La présente invention concerne une pince de mesure d'un courant circulant dans des conducteurs.

Les pinces de ce type comprennent généralement deux mâchoires reliées par une articulation et pourvues chacune d'un tronçon d'un circuit magnétique annulaire, chaque tronçon ayant une extrémité proximale et une extrémité distale par rapport à l'articulation. Les mâchoires sont articulées entre une position fermée dans laquelle les extrémités distales et proximales des tronçons sont respectivement en contact et une position ouverte dans laquelle les extrémités distales et proximales sont espacées.

Lorsque la pince est refermée sur un conducteur sous tension, le courant circulant dans le conducteur induit un flux magnétique dans le circuit magnétique annulaire ainsi fermé. Un organe de mesure associé à la pince mesure ce flux magnétique qui est proportionnel au courant et calcule la valeur du courant.

Pour éviter des pertes de flux magnétique et obtenir une mesure précise, il est nécessaire qu'un contact magnétique de bonne qualité soit établi au niveau des extrémités proximales et des extrémités distales des tronçons lorsque la pince est fermée. On connaît du document FR-A-2 673 727 une pince comportant des tronçons de circuit magnétique montés pour pivoter autour d'axes de débattement parallèles à l'axe de l'articulation de manière que les tronçons puissent être correctement appliqués l'un sur l'autre au niveau des extrémités distales et proximales.

Dans une installation comprenant plusieurs conducteurs et en particulier des conducteurs nus, l'opérateur manipulant la pince doit veiller à ne pas établir un court-circuit entre deux conducteurs adjacents par contact de ceux-ci avec le circuit magnétique. Pour limiter ce risque, un revêtement isolant recouvre les tronçons à l'exception des extrémités distales et proximales. Cependant avec les pinces du document précité, il existe un risque que les extrémités distales de la pince ouverte viennent en contact avec deux conducteurs adjacents et que du fait du débattement des tronçons par rapport aux mâchoires les extrémités proximales des tronçons soient mises en contact créant alors un court-circuit entre les deux conducteurs. Une telle mise en court-circuit présente un danger pour l'opérateur et risque de détériorer l'installation.

On a donc pensé à entourer une des extrémités distales d'un cache protecteur dans lequel l'extrémité distale est en renfoncement. Le cache permet le contact de l'extrémité distale ainsi équipée avec l'extrémité distale de l'autre tronçon mais empêche que l'extrémité distale vienne en contact avec un conducteur, de sorte que même si les extrémités proximales sont en contact il n'y a pas de court-circuit entre les conducteurs. Toutefois, le cache augmente l'encombrement de l'extrémité distale rendant ainsi plus difficile l'insertion de celle-ci entre les conducteurs à mesurer. En outre, un tel cache est très exposé à des chocs risquant de le détériorer, ce qui limite ou fait disparaître la protection. Par ailleurs, des particules diverses risquent de s'accumuler dans le renfoncement formé par le cache empêchant alors l'établissement d'un bon contact avec l'autre extrémité distale. De plus, le cache empêche tout contrôle visuel de la qualité du contact entre les extrémités distales.

Un but de l'invention est de prévoir une pince comprenant des moyens pour empêcher l'établissement d'un court-circuit entre deux conducteurs adjacents sans utilisation d'un cache sur les extrémités distales des tronçons de circuit magnétique.

En vue de la réalisation de ce but, on prévoit, selon l'invention, une pince de mesure d'un courant circulant dans des conducteurs, comprenant une première et une seconde mâchoires associées à au moins un organe de manoeuvres, les mâchoires étant reliées par une articulation et étant pourvues respectivement d'un premier et d'un second tronçons d'un circuit magnétique annulaire, chaque tronçon ayant une extrémité proximale et une extrémité distale par rapport à l'articulation et au moins le premier tronçon étant monté pour pivoter autour d'un axe de débattement parallèle à un axe de l'articulation, les mâchoires étant mobiles autour de cet axe d'articulation sous l'action de l'organe de manoeuvre entre une position fermée dans laquelle les extrémités distales et proximales des tronçons sont respectivement en contact et une position ouverte dans laquelle les extrémités distales et proximales sont espacées, caractérisée en ce qu'elle comprend en outre un organe d'écartement mobile entre une position active dans laquelle l'organe d'écartement a une partie formant une came coopérant au moins avec l'extrémité proximale du premier tronçon pour écarter positivement celle-ci de l'extrémité proximale du second tronçon au moins lorsque les extrémités distales sont espacées d'une distance supérieure ou égale à une distance de sécurité prédéterminée, et une position inactive dans laquelle l'organe d'écartement libère les mouvements relatifs des tronçons.

La distance de sécurité est déterminée de manière à correspondre à la distance minimale séparant deux conducteurs compte tenu de la tension à laquelle ceux-ci sont portés. Ainsi, les extrémités proximales sont maintenues écartées l'une de l'autre au moins tant qu'il existe un risque que les extrémités distales viennent en contact avec deux conducteurs adjacents. Le circuit magnétique est de la sorte maintenu ouvert au niveau des extrémités proximales, et le risque d'établissement d'un court-circuit est éliminé.

Selon un premier mode de réalisation, l'organe mobile en position inactive est associé à une butée de verrouillage des mâchoires en-deçà d'une position intermédiaire d'ouverture dans laquelle les extrémités distales sont espacées d'une distance égale à la distance de sécurité, l'organe mobile en position active échappant à cette butée. Toute ouverture de la pince au-delà de la distance de sécurité nécessite donc la mise en position active de l'organe mobile.

Selon un deuxième mode de réalisation, l'organe mobile s'étend entre au moins une surface de came portée par une mâchoire et une protubérance adjacente à l'extrémité proximale d'un tronçon de circuit magnétique monté articulé sur la mâchoire correspondante, la partie formant came de l'organe mobile s'étendant en regard de la protubérance correspondante du tronçon de circuit magnétique. L'ouverture de la pince provoque ainsi une activation automatique des moyens d'écartement.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- les figures 1, 2 et 3 sont des vues en élévation avec écorché d'une pince selon un premier mode de réalisation, respectivement en position fermée, en une position intermédiaire préalable à l'ouverture, et en position ouverte ;
- les figures 4, 5 et 6 sont des vues en élévation avec écorché représentant une pince selon un deuxième mode de réalisation, respectivement en position fermée, en position intermédiaire et en position ouverte.

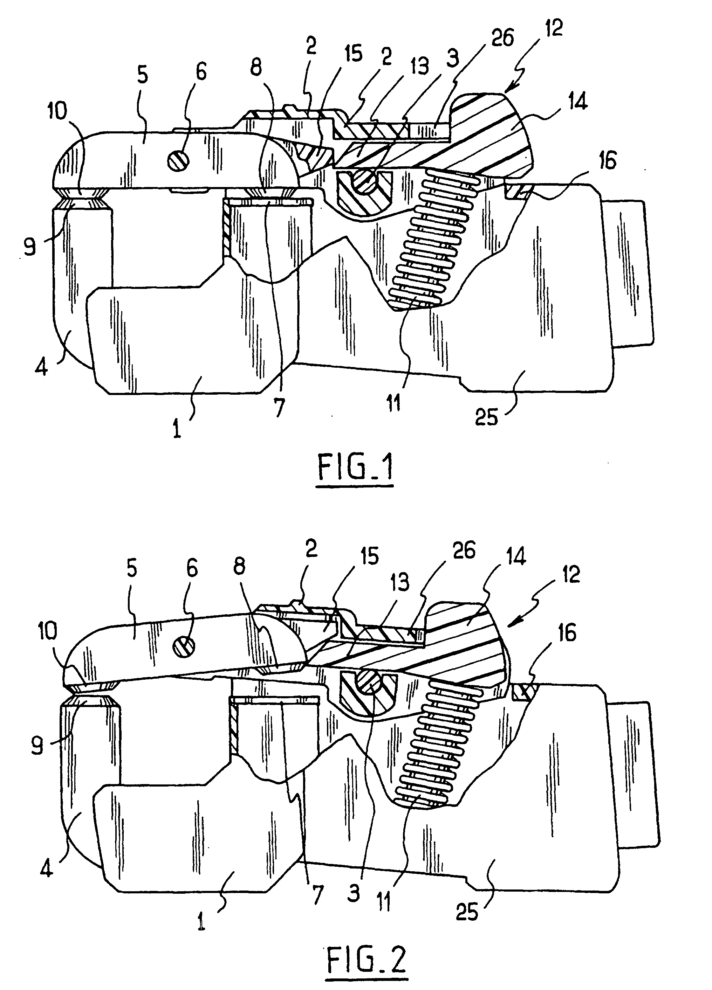

En référence aux figures 1 à 3, la pince selon le premier mode de réalisation comprend deux mâchoires 1 et 2, reliées l'une à l'autre par un axe d'articulation 3 ici perpendiculaire au plan de la feuille et prolongées au-delà de cet axe par des poignées 25, 26.

Un tronçon de circuit magnétique annulaire en forme de U 4 est solidaire de la mâchoire 1 et un tronçon de circuit magnétique annulaire 5 est monté sur la mâchoire 2 par l'intermédiaire d'un axe 6 parallèle à l'axe d'articulation 3 pour permettre un débattement angulaire du tronçon 5 par rapport à la mâchoire 2.

Chaque tronçon 4, 5 comprend une extrémité proximale 7, 8 et une extrémité distale 9, 10 par rapport à l'axe d'articulation 3. Les tronçons 4 et 5 sont réalisés en un matériau ferromagnétique recouvert d'un matériau isolant, seules les extrémités proximales 7, 8 et distales 9, 10 étant découvertes. Le circuit magnétique annulaire est associé de manière classique à un dispositif électrique de mesure du flux dans le circuit magnétique comprenant par exemple une bobine entourant au moins une partie du circuit magnétique et associée à un organe de mesure du courant circulant dans la bobine.

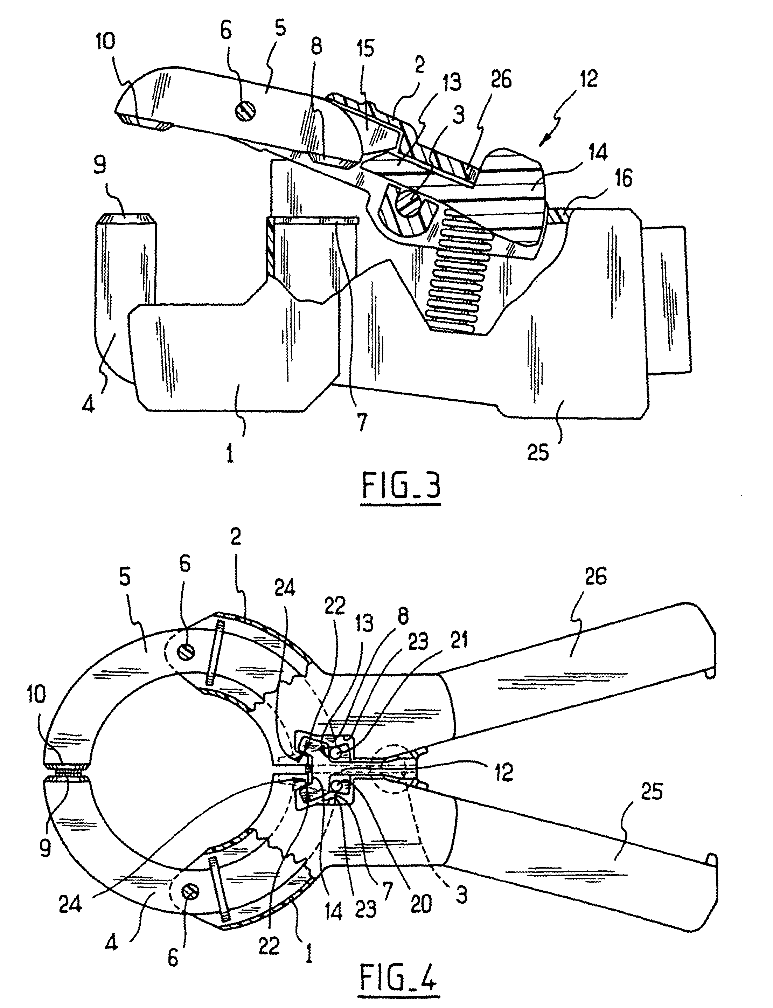

Les mâchoires 1, 2 sont articulées l'une à l'autre entre une position fermée dans laquelle les tronçons 4 et 5 sont en contact l'un avec l'autre par les extrémités proximales 7, 8 et distales 9, 10 pour former le circuit magnétique annulaire (voir la figure 1) et une position ouverte dans laquelle les extrémités proximales 7, 8 et les extrémités distales 9, 10 sont espacées (voir la figure 3). Un ressort 11 s'étendant entre les poignées 25 et 26 rappelle élastiquement les mâchoires dans leur position fermée.

Conformément à l'invention, la pince comprend des moyens d'écartement qui comportent un organe mobile 12 ayant une partie 13, ici une extrémité, formant came et une extrémité opposée 14 conformée en poussoir.

L'organe mobile 12 est monté sur la mâchoire 2 pour coulisser entre une position active, représentée à la figure 2, dans laquelle l'extrémité 13 formant came vient en appui sur une protubérance 15 solidaire du tronçon 5 au niveau de l'extrémité proximale 8 pour écarter l'extrémité proximale 8 de l'extrémité proximale 7, et une position inactive, représentée à la figure 1, dans laquelle l'organe mobile est en retrait par rapport à sa position active de sorte que l'extrémité 13 ne coopère plus avec la protubérance 15 et libère ainsi le tronçon 5 en débattement autour de l'axe 6.

Lorsque les mâchoires sont en position fermée et l'organe mobile 12 est en position inactive (figure 1), les extrémités distales et proximales sont respectivement en contact et l'extrémité 14 formant poussoir débouche au niveau de la poignée 26 pour s'étendre en regard d'une butée 16 solidaire de la poignée 25. Tout effort sur la mâchoire 2 tendant à ouvrir la pince amène ainsi l'extrémité 14 contre la butée 16 qui s'oppose au pivotement de la mâchoire 2 autour de l'axe d'articulation 3.

Lorsque l'organe mobile 12 est amené dans sa position active (figure 2) par l'opérateur, l'extrémité 14 échappe à la butée 16 tandis que l'extrémité 13 vient écarter l'extrémité proximale 8 de l'extrémité proximale 7 en coopérant avec la proéminence 15, les extrémités distales 9, 10 restant en contact. L'écartement est rendu possible par un léger pivotement de la mâchoire 2 autour de l'axe 3.

Il est alors possible en exerçant une pression sur l'extrémité 14 d'amener les mâchoires 1 et 2 dans leur position d'ouverture (figure 3).

La fermeture de la pince est opérée en effectuant les opérations inverses.

On comprend que, lorsque l'organe mobile est dans sa position active, le débattement angulaire du tronçon 5 autour de l'axe 6 est bloqué de telle sorte que le tronçon 5 soit dans une position dans laquelle les extrémités proximales sont écartées l'une de l'autre maintenant ainsi le circuit magnétique ouvert et ce, que les mâchoires soient ouvertes ou fermées.

A la fermeture, les extrémité distales arrivent en contact l'une contre l'autre alors que les extrémités proximales sont toujours maintenues écartées par l'organe mobile.

La butée 16 pourrait également être disposée de manière à permettre sans manoeuvre de l'organe mobile une ouverture des mâchoires 1 et 2 jusqu'à une position intermédiaire dans laquelle les extrémités distales 9 et 10 sont espacées d'une distance inférieure ou égale à une distance de sécurité prédéterminée. Il est alors possible d'ouvrir partiellement les mâchoires par exemple pour engager la pince autour d'un seul conducteur mais il reste nécessaire de manoeuvrer l'organe d'écartement 12 en position active si l'ouverture des mâchoires doit être supérieure à la distance de sécurité. La distance de sécurité est déterminée pour correspondre à la distance minimale séparant deux conducteurs adjacents dans les installations pour lesquelles la pince est adaptée. Cette distance minimale est proportionnelle à la différence de potentiel existant entre les conducteurs.

Une pince selon un deuxième mode de réalisation va maintenant être décrite en relation avec les figures 4 à 6, les éléments identiques ou analogues à ceux décrits précédemment portant dans la suite de la description une référence numérique identique.

La pince selon le deuxième mode de réalisation comprend deux mâchoires 1 et 2 reliées l'une à l'autre par un axe d'articulation 3 et prolongées au-delà de cet axe par des poignées 25, 26.

Un tronçon de circuit magnétique annulaire 4, 5 de forme semi-circulaire est monté pivotant sur chaque mâchoire 1, 2 par l'intermédiaire d'un axe 6 parallèle à l'axe d'articulation 3.

Les tronçons 4, 5 ont chacun une extrémité proximale 7, 8 et une extrémité distale 9, 10 par rapport à l'axe d'articulation 3.

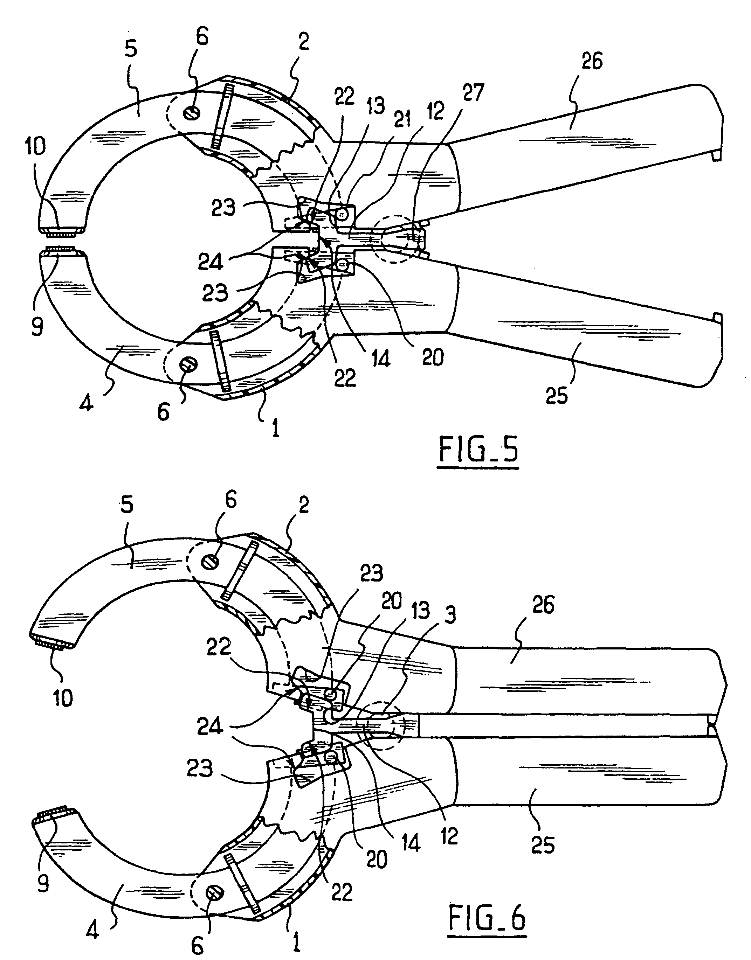

Comme précédemment, les mâchoires 1, 2 sont articulées l'une à l'autre entre une position fermée dans laquelle elles sont rappelées élastiquement et les tronçons 4 et 5 sont en contact l'un avec l'autre par les extrémités proximales 7, 8 et distales 9, 10 pour former le circuit magnétique annulaire (voir la figure 4), et une position ouverte dans laquelle les extrémités proximales 7, 8 et les extrémités distales 9, 10 sont espacées (voir la figure 6).

Le tronçon 4 du circuit magnétique comporte deux ergots 20 (dont un seul est visible sur la figure) adjacents à l'extrémité proximale 7 et s'étendant en saillie parallèlement à l'axe 6 de part et d'autre d'un plan contenant le circuit magnétique. De la même façon le tronçon 5 du circuit magnétique comporte deux ergots 21 (dont un seul est visible sur la figure) adjacents à l'extrémité proximale 8.

Les ergots 20 et 21 situés sur une même face du circuit magnétique s'étendent dans deux encoches 23 réalisées en correspondance dans deux côtés en regard des mâchoires 1, 2. Chaque encoche 23 comprend une surface de came 24.

Les moyens d'écartement comprennent deux organes mobiles 12 disposés de part et d'autre du plan contenant le circuit magnétique parallèlement à celui-ci et formés chacun d'une plaquette ayant une partie formant came 13 et un bord opposé 14 comportant deux redans 22 s'étendant en regard des surfaces de came 24 pour une position fermée de la pince. Les organes mobiles 12 sont de préférence maintenus en place par un étrier non représenté chevauchant les deux mâchoires.

Chaque organe mobile 12 est reçu dans le logement défini par deux encoches 23 pour s'étendre entre les surfaces de came 24 et les pions 20, 21 et être mobile entre une position inactive et une position active.

Lorsque les mâchoires 1, 2 sont en position fermée (figure 4), chaque organe mobile est en position inactive. Les surfaces de came 24 sont alors reçues entre les redans 22 et le bord 13 est simplement en contact avec les ergots 20, 21.

Au cours de l'ouverture des mâchoires (figure 5), les surfaces de came 24 prennent appui sur les redans 22 pour déplacer l'organe mobile vers sa position active. La partie formant came 13 pousse alors les ergots 20, 21 provoquant un pivotement des tronçons 4, 5 autour des axes 6 dans un sens d'écartement des extrémités proximales 7, 8 l'une de l'autre.

Lorsque les mâchoires 1, 2 sont en position ouverte (figure 6), les surfaces de came 24 ont poussé l'organe mobile entre les ergots 20, 21 interdisant ainsi tout rapprochement des extrémités proximales 7, 8.

Lors de la fermeture de la pince en raison du débattement limité des tronçons de circuit magnétique les ergots 20, 21 prennent appui sur l'organe mobile 12 pour le faire remonter et libérer les ergots 20, 21 en fin de fermeture. De préférence chaque organe mobile 12 comprend une queue 27 qui s'étend entre les mâchoires au-delà de la partie formant came 13 pour éviter un basculement de l'organe mobile lorsque la pince est en position ouverte. On évite ainsi un blocage des mâchoires en position ouverte.

On remarquera que dans ce mode de réalisation l'organe mobile est amené en position active automatiquement dès le début de l'ouverture des mâchoires. Par ailleurs, à la fermeture, les extrémité distales arrivent en contact l'une contre l'autre alors que les extrémités proximales sont toujours maintenues écartées par l'organe mobile.

Bien entendu l'invention n'est pas limitée au mode de réalisation décrit et on peut y apporter des variantes de réalisation sans sortir du cadre de l'invention tel que défini par les revendications.

En particulier, dans le second mode de réalisation, l'organe mobile en position active pourra être agencé pour venir s'insérer entre les extrémités proximales des tronçons de circuit magnétique annulaire.

On pourra également agencer les surfaces de came 24 et les redans 22 (modification de leur positionnement relatif) de manière que les organes mobiles 12 ne soient maintenus en position active que lorsque les extrémités distales 9, 10 sont espacées d'une distance supérieure à la distance de sécurité.

## Revendications

1. Pince de mesure d'un courant circulant dans des conducteurs, comprenant une première et une seconde mâchoires (1, 2) associées à au moins un organe de manoeuvre (25, 26), les mâchoires (1, 2) étant reliées par une articulation (3) et étant pourvues respectivement d'un premier et d'un second tronçons (4, 5) d'un circuit magnétique annulaire, chaque tronçon (4, 5) ayant une extrémité proximale (7, 8) et une extrémité distale (9, 10) par rapport à l'articulation et au moins le premier tronçon (5) étant monté pour pivoter autour d'un axe de débattement (6) parallèle à un axe de l'articulation (3), les mâchoires étant mobiles autour de cet axe d'articulation sous l'action de l'organe de manoeuvre entre une position fermée dans laquelle les extrémités distales (9, 10) et proximales (7, 8) des tronçons (4, 5) sont respectivement en contact et une position ouverte dans laquelle les extrémités distales (9, 10) et proximales (7, 8) sont espacées, **caractérisée en ce qu'**elle comprend en outre un organe d'écartement mobile (12) entre une position active dans laquelle l'organe d'écartement a une partie (13) formant une came coopérant au moins avec l'extrémité proximale (8) du premier tronçon (5) pour écarter positivement celle-ci de l'extrémité proximale (7) du second tronçon (4) au moins lorsque les extrémités distales (9, 10) sont espacées d'une distance supérieure ou égale à une distance de sécurité prédéterminée, et une position inactive dans laquelle l'organe d'écartement (12) libère les mouvements relatifs des tronçons.

2. Pince de mesure selon la revendication 1, **caractérisée en ce que** l'organe d'écartement (12) en position inactive est associé à une butée (16) de verrouillage des mâchoires en-deçà d'une position intermédiaire d'ouverture dans laquelle les extrémités distales (9, 10) sont espacées d'une distance égale à la distance de sécurité, et **en ce que** l'organe d'écartement en position active échappe à cette butée.

3. Pince de mesure selon la revendication 2, **caractérisée en ce que** l'organe d'écartement (12) est monté pour coulisser sur la première mâchoire (5) et la butée (16) est solidaire de la seconde mâchoire (4), l'organe d'écartement ayant une extrémité (14) opposée à l'extrémité formant came s'étendant en regard de la butée lorsque les mâchoires (1, 2) sont en position fermée et que l'organe d'écartement est en position inactive de manière que la butée s'oppose à l'ouverture des mâchoires, cette extrémité (14) de l'organe d'écartement s'étendant en retrait de la butée lorsque l'organe d'écartement est en position active.

4. Pince de mesure selon la revendication 3, **caractérisée en ce que** l'extrémité (14) opposée à l'extrémité formant came (13) a une forme de poussoir apte à être manipulé manuellement.

5. Pince de mesure selon la revendication 1, **caractérisée en ce que**, l'organe d'écartement (12) s'étend entre au moins une surface de came portée par une mâchoire (1, 2) et une protubérance (20, 21) adjacente à l'extrémité proximale (7, 8) d'un tronçon de circuit magnétique monté articulé sur la mâchoire correspondante, la partie formant came (13) de l'organe d'écartement s'étendant en regard de la protubérance correspondante du tronçon de circuit magnétique.

6. Pince de mesure selon la revendication 5, **caractérisée en ce que** chaque protubérance comprend un pion (20, 21) s'étendant latéralement en saillie.

7. Pince de mesure selon la revendication 5, **caractérisée en ce que** les deux tronçons (4, 5) de circuit magnétique sont montés pour pivoter sur la mâchoire correspondante et **en ce que** l'organe d'écartement (12) comporte une queue (27) s'étendant entre les mâchoires au-delà de la partie formant came (13).

## Patentansprüche

1. Messzange zum Messen eines in Stromleitern fließenden Stromes, umfassend eine erste und eine zweite Backe (1, 2), die mit mindestens einem Betätigungselements (25, 26) verbunden sind, wobei die Backen (1, 2) über eine Gelenkverbindung (3) verbunden und mit einem ersten bzw. mit einem zweiten Abschnitt (4, 5) eines ringförmigen Magnetkreises versehen sind, wobei jeder Abschnitt (4, 5) in Bezug auf die Gelenkverbindung ein proximales Ende (7, 8) und ein distales Ende (9, 10) hat und mindestens der erste Abschnitt (5) derart gelagert ist, dass er sich um eine Schwenkachse (6) drehen kann, die parallel zu einer Achse der Gelenkverbindung (3) verläuft, wobei die Backen unter der Wirkung des Betätigungselements um diese Gelenkverbindungsachse zwischen einer geschlossenen Stellung, in der die distalen Enden (9, 10) und die proximalen Enden (7, 8) der Abschnitte (4, 5) jeweils in Kontakt sind, und einer offenen Stellung beweglich sind, in der die distalen Enden (9, 10) und die proximalen Enden (7, 8) zueinander beabstandet sind, **dadurch gekennzeichnet, dass** sie ferner ein Spreizelement (12) hat, das zwischen einer aktiven Stellung, in der das Spreizelement einen eine Nocke bildenden Abschnitt (13) hat, der mindestens mit dem proximalen Ende (8) des ersten Abschnittes (5) zusammenwirkt, um dieses positiv von dem proximalen Ende (7) des zweiten Abschnittes (4) zu entfernen, zumindest wenn die distalen Enden (9, 10) um einen Abstand voneinander entfernt sind, der größer oder gleich einem vorgegebenen Sicherheitsabstand ist, und einer inaktiven Stellung beweglich ist, in der das Spreizelement (12) die Relativbewegungen der Abschnitte freigibt.

2. Messzange nach Anspruch 1, **dadurch gekennzeichnet, dass** das Spreizelement (12) in der inaktiven Stellung einem Anschlag (16) zur Verriegelung der Backen diesseits einer mittleren Offenstellung zugeordnet ist, in der die distalen Enden (9, 10) um einen Abstand voneinander entfernt sind, der gleich dem Sicherheitsabstand ist, und dass sich das Spreizelement in der aktiven Stellung von diesem Anschlag löst.

3. Messzange nach Anspruch 2, **dadurch gekennzeichnet, dass** das Spreizelement (12) verschiebbar auf der ersten Backe (5) gelagert und der Anschlag (16) fest mit der zweiten Backe (4) verbunden ist, wobei das Spreizelement ein dem die Nocke bildenden Ende entgegengesetztes Ende (14) hat, das dem Anschlag gegenüberliegt, wenn die Backen (1, 2) in geschlossener Stellung sind und wenn das Spreizelement in der inaktiven Stellung ist, derart, dass sich der Anschlag dem Öffnen der Backen widersetzt, wobei dieses Ende (14) des Spreizelements von dem Anschlag zurückgezogen ist, wenn das Spreizelement in der aktiven Stellung ist.

4. Messzange nach Anspruch 3, **dadurch gekennzeichnet, dass** das dem die Nocke (13) bildenden Ende entgegengesetzte Ende (14) eine Druckknopfform hat, die sich für eine manuelle Betätigung eignet.

5. Messzange nach Anspruch 1, **dadurch gekennzeichnet, dass** sich das Spreizelement (12) zwischen wenigstens einer Nockenfläche, die von einer Backe (1, 2) getragen wird, und einem Vorsprung (20, 21) erstreckt, der an das proximale Ende (7, 8) eines Magnetkreisabschnittes angrenzt, der an der entsprechenden Backe angelenkt ist, wobei der die Nocke (13) bildende Abschnitt des Spreizelements dem entsprechenden Vorsprung des Magnetkreisabschnittes gegenüberliegt.

6. Messzange nach Anspruch 5, **dadurch gekennzeichnet, dass** jeder Vorsprung einen Zapfen (20, 21) umfasst, der seitlich absteht.

7. Messzange nach Anspruch 5, **dadurch gekennzeichnet, dass** die beiden Magnetkreisabschnitte (4, 5) schwenkbar an der entsprechenden Backe gelagert sind und dass das Spreizelement (12) einen Schaft (27) umfasst, der sich zwischen den Backen jenseits des die Nocke (13) bildenden Abschnittes erstreckt.

## Claims

1. A measuring clamp for measuring an electric current carried by conductors, the clamp comprising first and second jaws (1, 2) associated with at least one drive member (25, 26), the jaws (1, 2) being connected together by a hinge (3) and being provided with respective first and second segments (4, 5) of an annular magnetic circuit, each segment (4, 5) having a proximal end (7, 8) and a distal end (9, 10) relative to the hinge, and at least the first segment (5) being mounted to rock about a rocker axis (6) parallel to a hinge axis (3), the jaws being movable about the hinge axis under the action of the drive member between a closed position in which the distal ends (9, 10) and the proximal ends (7, 8) of the segments (4, 5) are respectively in contact, and an open position in which the distal ends (9, 10) and the proximal ends (7, 8) are spaced apart, the clamp being **characterized in that** it further includes a spacer member (12) movable between an active position in which the spacer member has a cam-forming portion (13) co-operating at least with the proximal end (8) of the first segment (5) to space it apart positively from the proximal end (7) of the second segment (4) at least while the distal ends (9, 10) are spaced apart by a distance that is greater than or equal to a predetermined safety distance, and an inactive position in which the spacer member (12) releases relative movement between the segments.

2. A measuring clamp according to claim 1, **characterized in that** the spacer member (12) in the inactive position is associated with a stop (16) for locking the jaws closer than an intermediate open position in which the distal ends (9, 10) are spaced apart by a distance equal to the safety distance, and **in that** the spacer member in the active position escapes from this stop.

3. A measuring clamp according to claim 2, **characterized in that** the spacer member (12) is mounted to slide on the first jaw (5) and the stop (16) forms a part of the second jaw (4), the spacer member having an end (14) opposite its cam-forming end and extending to face the stop when the jaws (1, 2) are in the closed position, and when the spacer member is in the inactive position so that the stop opposes opening of the jaws, said end (14) of the spacer member being withdrawn from the stop when the spacer member is in the active position.

4. A measuring clamp according to claim 3, **characterized in that** the end (14) opposite from the cam-forming end (13) is in the form of a pusher suitable for being operated manually.

5. A measuring clamp according to claim 1, **characterized in that** the spacer member (12) extends between at least one cam surface carried by one jaw (1, 2) and an adjacent projection (20, 21) at the proximal end (7, 8) of a magnetic circuit segment mounted to rock on the corresponding jaw, the cam-forming portion (13) of the spacer member extending in register with the corresponding projection of the magnetic circuit segment.

6. A measuring clamp according to claim 5, **characterized in that** each projection comprises a stud (20, 21) projecting laterally.

7. A measuring clamp according to claim 5, **characterized in that** the two segments (4, 5) of the magnetic circuit are mounted to rock on the corresponding jaws, and **in that** the spacer member (12) has a tail (27) extending between the jaws beyond the cam-forming portion (13).
